# EUROPEAN PATENT APPLICATION

(11) **EP 2 682 195 A2**
(43) Date of publication of application: **08.01.2014**
(21) Application number: 13173702.5
(22) Date of filing: 26.06.2013
(51) Int. Cl.: B06B 1/02

(54) **Capacitive transducer**

(30) Priority: 06.07.2012 JP 2012151938
(71) Applicant: Canon Kabushiki Kaisha, Tokyo 146-8501 (JP)
(72) Inventor: Torashima, Kazutoshi, Tokyo,, Tokyo 146-8501 (JP); Akiyama, Takahiro, Tokyo,, Tokyo 146-8501 (JP)
(74) Representative: TBK

(57) **Abstract**

Provided is a capacitive transducer including an element including a plurality of cells: each of the plurality of cells including: a first electrode; and a vibrating film including a second electrode, the second electrode being opposed to the first electrode with a gap; and a vibrating film supporting portion that supports the vibrating film so as to form the gap, in which the element includes a first cell and a second cell, the first cell including the vibrating film having a first spring constant, the second cell including the vibrating film having a second spring constant lower than the first spring constant; and a voltage to be applied between the first electrode and the second electrode of the first cell is higher than a voltage to be applied between the first electrode and the second electrode of the second cell.

## Description

### BACKGROUND OF THE INVENTION

### Field of the Invention

The present invention relates to a capacitive transducer to be used as an ultrasonic transducer element or the like, and a method of manufacturing the capacitive transducer.

### Description of the Related Art

Hitherto, micromechanical members to be manufactured using micromachining technology may be processed on the order of micrometers, and various functional microelements are materialized using such micromechanical members. A capacitive transducer using such technology is being researched as an alternative to a transducer using a piezoelectric element. With such a capacitive transducer, an acoustic wave, such as an ultrasonic wave, a sonic wave, and a photoacoustic wave (hereinafter sometimes represented by ultrasonic wave), may be transmitted and received using vibrations of a vibrating film, and in particular, excellent broadband characteristics (characteristics with a relatively high receiving sensitivity or transmitting sensitivity in a wide frequency domain) in a liquid may be obtained with ease.

As the above-mentioned technology, a capacitive transducer that realizes broadband characteristics has been proposed, which includes a cell including a vibrating film having a high spring constant and a cell including a vibrating film having a low spring constant (see US Patent No. 5,870,351). Another capacitive transducer that realizes broadband characteristics has been proposed, which has a group of multiple cells having a high spring constant and a group of multiple cells having a low spring constant (see US Patent Application Publication No. 2007/0059858).

The capacitive transducers as described above are capable of transmission and reception driving by applying a common voltage to a common electrode. In this case, however, the electromechanical transformer ratio differs among multiple kinds of cells, that is, the cell including the vibrating film having a high spring constant and the cell including the vibrating film having a low spring constant. Therefore, although broadband characteristics are realized, the transmitting sensitivity representing the ratio of a transmitted sound pressure to the voltage or the receiving sensitivity representing the ratio of a received electric signal to a received sound pressure may be lowered because the electromechanical transformer ratio differs among the multiple kinds of cells.

### SUMMARY OF THE INVENTION

In view of the above-mentioned problem, according to an exemplary embodiment of the present invention, there is provided a capacitive transducer, including an element including a plurlity of cells: each of the plurality of cells including: a first electrode; a vibrating film including a second electrode, the second electrode being opposed to the first electrode with a gap; and a vibrating film supporting portion that supports the vibrating film so as to form the gap. The element includes a first cell and a second cell, the first cell including the vibrating film having a first spring constant, the second cell including the vibrating film having a second spring constant lower than the first spring constant. A voltage to be applied between the first electrode and the second electrode of the first cell is higher than a voltage to be applied between the first electrode and the second electrode of the second cell.

Further features of the present invention will become apparent from the following description of exemplary embodiments with reference to the attached drawings.

### BRIEF DESCRIPTION OF THE DRAWINGS

FIGS. 1A and 1B are diagrams illustrating a capacitive transducer according to an embodiment and Example 1 of the present invention.

FIGS. 2A and 2B are diagrams illustrating a capacitive transducer according to another embodiment and Example 2 of the present invention.

FIGS. 3A, 3B, 3C, 3D, and 3E are diagrams illustrating an exemplary method of manufacturing the capacitive transducer according to the present invention.

FIG. 4 is a diagram illustrating an exemplary device for acquiring test object information by using the capacitive transducer according to the present invention.

### DESCRIPTION OF THE EMBODIMENTS

Preferred embodiments of the present invention will now be described in detail in accordance with the accompanying drawings.

The feature of a capacitive transducer according to the present invention is to include a first cell including a vibrating film having a first spring constant, a second cell including a vibrating film having a second spring constant lower than the first spring constant, and first and second voltage applying units configured to apply voltages between first and second electrodes of the first and second cells, respectively. The electromechanical transformer ratio becomes higher as the ratio of an applied voltage to a pull-in voltage becomes higher. The pull-in voltage as used herein refers to an applied voltage between the first electrode and the second electrode at which the electrostatic attractive force becomes larger than a restoring force of the vibrating film. When applied with a voltage equal to or higher than the pull-in voltage, the vibrating film is brought into contact with a lower surface of a cavity. In the case where the applied voltage is set so as not to exceed the pull-in voltage, the electromechanical transformer ratio is proportional to the product of the capacitance between the first electrode and the second electrode and the electric field intensity. The electric field intensity is proportional to the applied voltage, and hence the electromechanical transformer ratio is proportional to the product of the capacitance between the first electrode and the second electrode and the applied voltage, and becomes maximum when the pull-in voltage is applied. The pull-in voltage is proportional to about 0.5 power of the spring constant and to about 1.5 power of an effective gap between upper and lower electrodes. The effective gap as used herein refers to the sum of a cavity gap and a value obtained by dividing the vibrating film formed between the upper and lower electrodes by the relative permittivity. The pull-in voltage of the cell having a high spring constant of the vibrating film is higher than the pull-in voltage of the cell having a low spring constant of the vibrating film. Therefore, by applying the voltages between the electrodes as exemplified by the structure of the present invention, the applied voltages have substantially the same ratio to the pull-in voltages, and hence the transmitting sensitivity or the receiving sensitivity can be improved. Thus, according to the capacitive transducer of the present invention, the receiving or transmitting frequency band width can be increased, and the transmitting sensitivity or the receiving sensitivity can be improved.

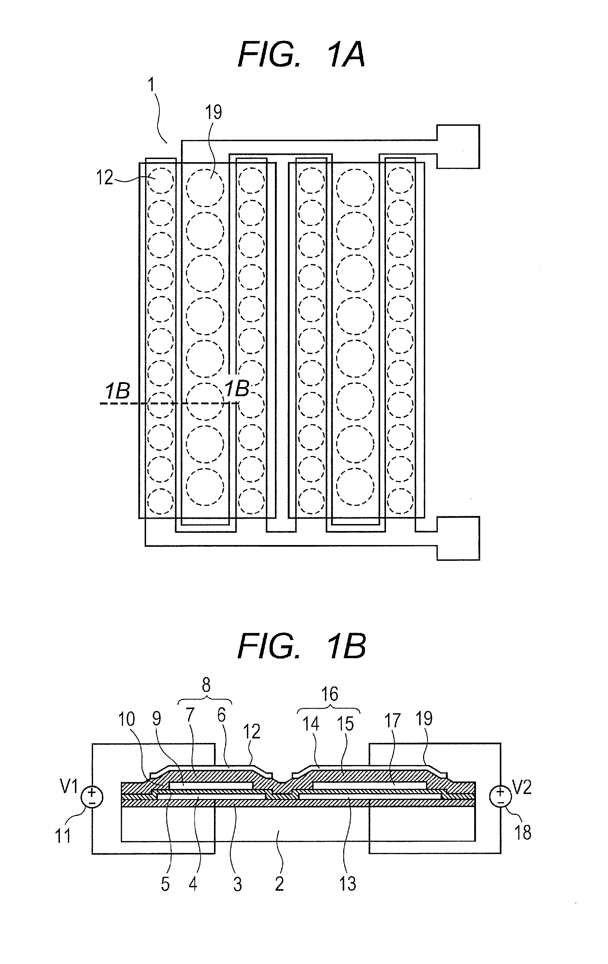

Referring to the accompanying drawings, an embodiment of the present invention is described below. FIG. 1A is a top view of a capacitive transducer according to this embodiment, and FIG. 1B is a cross-sectional view taken along the line 1B-1B of FIG. 1A. This embodiment exemplifies multiple capacitive transducers (elements) 1 each including multiple first cells 12 and multiple second cells 19. FIGS. 1A and 1B illustrate only two capacitive transducers, but the number of the transducers is not limited thereto. The multiple capacitive transducers each include twenty-two first cells 12 and eight second cells 19, but the numbers of the respective cells are not limited thereto. The cells can be arranged in various ways.

The first cell 12 includes a substrate 2, an insulating film 3 formed on the substrate 2, a first electrode 4 formed on the insulating film 3, and an insulating film 5 formed on the first electrode 4. The first cell 12 further includes a vibrating film 8, a vibrating film supporting portion 10 that supports the vibrating film 8, and a cavity (gap) 9. The vibrating film 8 includes a second electrode 6 opposed to the first electrode 4, and a membrane 7. In the case where the substrate 2 is an insulating substrate such as a glass substrate, the insulating film 3 may not be formed. The first cell 12 further includes a first voltage applying unit 11 for applying a voltage between the first electrode and the second electrode of the first cell 12.

The second cell 19 has substantially the same structure as that of the first cell 12. In the second cell 19, a vibrating film 16 has a spring constant lower than that of the vibrating film 8 of the first cell 12. In the example of FIG. 1B, the vibrating film 16 is made of the same material and has the same thickness as the vibrating film 8. The diameter of the vibrating film 16 is set to be larger than that of the vibrating film 8, thereby decreasing the spring constant. In this embodiment, the shape of the vibrating film is circular, but may be square, rectangular, or the like. The second cell 19 further includes a second voltage applying unit 18 for applying a first electrode and a second electrode of the second cell 19. The second cell 19 includes a first electrode 13, a second electrode 14, a membrane 15, and a cavity 17.

The membranes 7 and 15 of the vibrating films 8 and 16 are insulating films. In particular, it is desired that the membranes 7 and 15 be formed of a silicon nitride film because the silicon nitride film can be formed with a small tensile stress of, for example, 300 MPa or less so that the vibrating films can be prevented from being greatly deformed by a residual stress of the silicon nitride film. The membranes 7 and 15 of the vibrating films 8 and 16 are not necessarily insulating films. For example, monocrystalline silicon having a low resistivity of 1 Ωcm or less may be used for the membranes 7 and 15. In this case, the membrane may be used also as the second electrode. As described above, the spring constant of the vibrating film 16 of the second cell 19 is lower than the spring constant of the vibrating film 8 of the first cell 12. Therefore, the receiving frequency band width or the transmitting frequency band width can be increased.

When a common voltage is applied to the first electrodes 4 and 13 or the second electrodes 6 and 14, the first cell 12 has an electromechanical transformer ratio lower than that of the second cell 16. This is because the spring constant of the vibrating film 16 of the second cell 19 is lower than the spring constant of the vibrating film 6 of the first cell 12 and hence a pull-in voltage of the cell having a high spring constant of the vibrating film is higher than a pull-in voltage of the cell having a low spring constant of the vibrating film. As described above, the pull-in voltage as used herein refers to an applied voltage between the electrodes at which the electrostatic attractive force becomes larger than a restoring force of the vibrating film. The electromechanical transformer ratio becomes higher as the ratio of the applied voltage to the pull-in voltage becomes higher.

In this embodiment, a voltage to be applied between the first electrode and the second electrode of the first cell having a high spring constant of the vibrating film is set to be higher than a voltage to be applied between the first electrode and the second electrode of the second cell having a low spring constant of the vibrating film. In other words, for example, a voltage to be applied to the first electrode 4 of the first cell having a high pull-in voltage is set to be higher than a voltage to be applied to the first electrode 13 of the second cell having a low pull-in voltage. Therefore, by applying the voltages as exemplified by this structure, the transmitting sensitivity or the receiving sensitivity can be improved. In this manner, the receiving frequency band width or the transmitting frequency band width can be increased, and the transmitting sensitivity or the receiving sensitivity can be improved.

Alternatively, the capacitive transducer may further include a plurality of the first cells or a plurality of the second cells, and the first electrodes or the second electrodes of the plurality of the first cells or the plurality of the second cells may be electrically coupled to one another. This structure in which the electrodes are coupled to one another eliminates the need of providing a voltage applying unit in each cell, and hence the frequency band width can be increased and the receiving sensitivity or the transmitting sensitivity can be improved with the use of a minimum number of the voltage applying units.

The area of the vibrating film of the first cell may be set to be smaller than the area of the vibrating film of the second cell, and the thickness of the vibrating film of the first cell may be set to be equal to the thickness of the vibrating film of the second cell. According to this structure, the cell having a high spring constant of the vibrating film and the cell having a low spring constant of the vibrating film can be manufactured in the same manufacturing process. Therefore, the capacitive transducer can be manufactured at low cost. In the case where the thickness of the vibrating film of the first cell is not equal to the thickness of the vibrating film of the second cell, for example, in the case where one of the vibrating films is etched after the film formation or the vibrating films are formed at different thicknesses, the ratio between the spring constant of the vibrating film of the first cell and the spring constant of the vibrating film of the second cell is liable to fluctuate. If the ratio between the spring constant of the vibrating film of the first cell and the spring constant of the vibrating film of the second cell fluctuates, the transmitting or receiving sensitivity or the frequency band width of the capacitive transducer is not always set to a desired band. Therefore, this structure having the same vibrating film thickness can reduce the fluctuations in transmitting sensitivity, receiving sensitivity, and frequency band width.

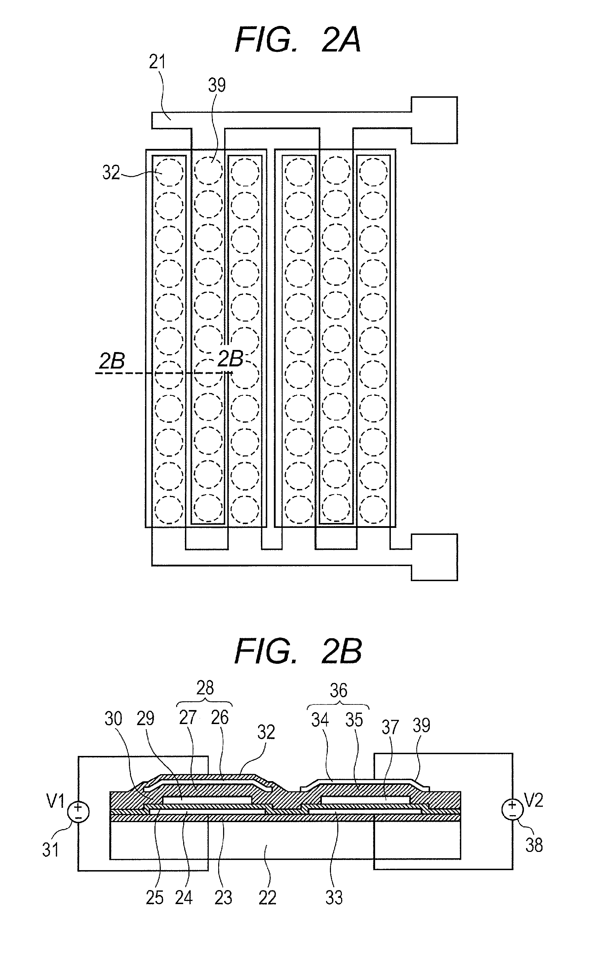

Alternatively, the thickness of the vibrating film of the first cell may be set to be larger than the thickness of the vibrating film of the second cell, and the area of the vibrating film of the first cell may be set to be equal to the area of the vibrating film of the second cell. According to this structure, the cells have the same shape when viewed from above as illustrated in FIG. 2A, and hence the radiation impedances are matched among all the cells. FIG. 2B is a cross-sectional view taken along the line 2B-2B of FIG. 2A. The radiation impedance as used herein refers to the ratio between the vibration speed of the vibrating film and a force (pressure) acting on the outside (air, liquid medium, or the like) from the vibrating film, and depends on the shape of the cell and the shape of the vibrating film. In this structure, the cells have the same radiation impedance, and hence the vibrating films of the cells are vibrated in the same manner, which can prevent an undesired vibration and ensure the operation efficiency and stability. The undesired vibration as used herein refers to the case where the cells are vibrated with different phases because of different radiation impedances of the cells.

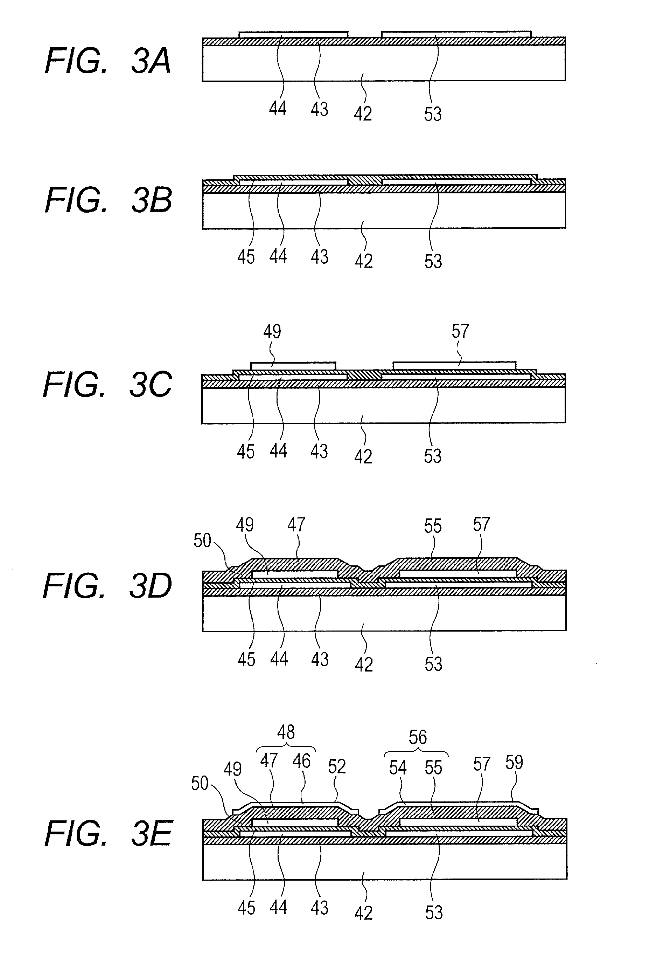

Referring to FIGS. 3A to 3E, an exemplary manufacturing method according to this embodiment is described below. FIGS. 3A to 3E are cross-sectional views of the capacitive transducer, illustrating substantially the same structure as that of FIGS. 1A and 1B. FIGS. 3A to 3E correspond to the cross sections taken along the line 1B-1B of FIG. 1A.

As illustrated in FIG. 3A, an insulating film 43 is formed on a substrate 42. The substrate 42 is a silicon substrate. The insulating film 43 is used for insulating the substrate 42 from the first electrode. In the case where the substrate 42 is an insulating substrate such as a glass substrate, the insulating film 43 is not always required to be formed. It is desired that the substrate 42 have a small surface roughness. If the surface roughness is large, the surface roughness is transferred even in a film forming step following this step, and the distance between the first electrode and the second electrode fluctuates among cells because of the surface roughness. The fluctuations in distance are responsible for the fluctuations in electromechanical transformer ratio and the fluctuations in sensitivity and band. It is therefore desired that the substrate 43 have a small surface roughness. First electrodes 44 and 53 are subsequently formed. It is desired that the first electrodes 44 and 53 be made of a conductive material having a small surface roughness. Examples of the material include titanium and aluminum. If the surface roughness of the first electrode is large, the distance between the first electrode and the second electrode fluctuates among cells and elements because of the surface roughness. Thus, similarly to the substrate, a conductive material having a small surface roughness is desired.

Next, as illustrated in FIG. 3B, an insulating film 45 is formed. It is desired that the insulating film 45 be made of an insulating material having a small surface roughness. The insulating film 45 is formed in order to prevent an electrical short circuit or a dielectric breakdown between the first electrode and the second electrode when a voltage is applied between the first electrode and the second electrode. In the case where the capacitive transducer is driven with a low voltage, the insulating film 45 is not always required to be formed because the membrane serves as an insulator. Another purpose of forming the insulating film 45 is to prevent the first electrode from being etched when a sacrificial layer is removed in a step following this formation step. The insulating film 45 is not always required to be formed in the case where the first electrode is not etched depending on the type of an etchant and an etching gas used when the sacrificial layer is removed. If the surface roughness of the insulating film 45 is large, the distance between the first electrode and the second electrode fluctuates among cells because of the surface roughness. Thus, similarly to the substrate 42, an insulating film having a small surface roughness is desired. The insulating film 45 is, for example, a silicon nitride film or a silicon oxide film.

Next, as illustrated in FIG. 3C, sacrificial layers 49 and 57 are formed. It is desired that the sacrificial layers 49 and 57 be made of a material having a small surface roughness. If the surface roughness of the sacrificial layer is large, the distance between the first electrode and the second electrode fluctuates among cells because of the surface roughness. Thus, similarly to the substrate, a sacrificial layer having a small surface roughness is desired. It is also desired that the material has a high etching rate in order to shorten an etching time period of etching for removing the sacrificial layer. The sacrificial layer is required to be made of such a material that the insulating film and the membrane are hardly etched by an etchant or an etching gas for removing the sacrificial layer. If the insulating film and the membrane are etched by an etchant or an etching gas for removing the sacrificial layer, the thickness of the vibrating films and the distance between the first electrode and the second electrode are liable to fluctuate. The fluctuations in thickness of the vibrating films and the fluctuations in distance between the first electrode and the second electrode are responsible for the fluctuations in sensitivity and band among cells. In the case where the insulating film and the membrane are silicon nitride films or silicon oxide films, a small surface roughness can be obtained, and an etchant or an etching gas that hardly etches the insulating film and the membrane can be used. Desired materials for the sacrificial layers include amorphous silicon, polyimide, and chromium. In particular, a chromium etchant is desired in the case where the insulating film and the membrane are silicon nitride films or silicon oxide films, because the chromium etchant hardly etches the silicon nitride films or the silicon oxide films.

Next, as illustrated in FIG. 3D, membranes 47 and 55 are formed. It is desired that the membranes 47 and 55 have a low tensile stress of, for example, 300 MPa or less. The stress of a silicon nitride film can be controlled, and a low tensile stress of 300 MPa or less can be obtained. In the case where the membrane has a compressive stress, the membrane causes sticking or buckling to be greatly deformed. In the case where the membrane has a large tensile stress, the membrane may be broken. It is therefore desired that the membranes 47 and 55 have a low tensile stress. The membranes 47 and 55 are made of, for example, a silicon nitride film whose stress can be controlled to obtain a low tensile stress.

Further, etching holes (not shown) are formed, and the sacrificial layers 49 and 57 are removed via the etching holes, followed by sealing the etching holes. For example, the etching holes can be sealed with a silicon nitride film or a silicon oxide film. The sacrificial layer removal step or the sacrificial layer sealing step may be performed after the formation of second electrodes.

Next, as illustrated in FIG. 3E, second electrodes 46 and 54 are formed. It is desired that the second electrodes 46 and 54 be made of a material having a small residual stress. Examples of the material include aluminum. In the case where the sacrificial layer removal step or the sacrificial layer sealing step is performed after the formation of the second electrodes, it is desired that the second electrodes be made of a material that is resistant to etching of the sacrificial layers and is heat resistant. Examples of the material include titanium. In this manner, a first cell 52 including a vibrating film 48 that has a large spring constant and includes the second electrode 46 and the membrane 47, and a second cell 59 including a vibrating film 56 that has a small spring constant and includes the second electrode 54 and the membrane 55 are formed.

As described above, the manufacturing method includes the step of forming the first electrodes of the first and second cells, the step of forming the sacrificial layers on the first electrodes in order to form the gaps of the first and second cells, the step of forming at least a part of the vibrating films of the first and second cells on the sacrificial layers, and the step of removing the sacrificial layers. In the step of forming the sacrificial layers, the area of a sacrificial layer for forming the gap of the first cell is set to be smaller than the area of a sacrificial layer for forming the gap of the second cell. In the step of forming at least a part of the vibrating films of the first and second cells, the thickness of the vibrating film of the first cell is set to be equal to the thickness of the vibrating film of the second cell. On the other hand, a method of manufacturing a capacitive transducer according to Example 2 to be described later is modified as follows. Specifically, in the step of forming the sacrificial layers, the area of the sacrificial layer for forming the gap of the first cell is set to be equal to the area of the sacrificial layer for forming the gap of the second cell. In the step of forming at least a part of the vibrating films of the first and second cells, the thickness of the vibrating film of the first cell is set to be larger than the thickness of the vibrating film of the second cell. The manufacturing methods described above can manufacture a sensitive capacitive transducer having a wide receiving frequency band width or transmitting frequency band width and an improved transmitting sensitivity or receiving sensitivity.

Now, the present invention is described in detail below by way of more specific examples.

(Example 1)

Example 1 of the present invention corresponds to the embodiment described above with reference to FIGS. 1A and 1B. Example 1 exemplifies multiple capacitive transducers 1 each including multiple first cells 12 and multiple second cells 19. The multiple capacitive transducers each include 22 first cells 12 and 8 second cells 19, but the numbers of the first cells 12 and the second cells 19 are not limited thereto. The arrangement of the cells and the shape of the vibrating film are determined as appropriate.

The first cell 12 includes a silicon substrate 2 having a thickness of 300 µm, an insulating film 3 formed on the silicon substrate 2, a first electrode 4 formed on the insulating film 3, and an insulating film 5 formed on the first electrode 4. The first cell 12 further includes a vibrating film 8, a vibrating film supporting portion 10 that supports the vibrating film 8, and a cavity 9. The vibrating film 8 includes a second electrode 6 and a membrane 7. The cavity 9 has a height of 100 nm. The first cell 12 further includes a voltage applying unit 11.

The insulating film 3 is a silicon oxide film having a thickness of 1 µm formed by thermal oxidation. The insulating film 5 is a silicon oxide film having a thickness of 100 nm formed by plasma-enhanced chemical vapor deposition (PE-CVD). The first electrode is made of titanium and has a thickness of 50 nm. The second electrode 6 is made of aluminum and has a thickness of 100 nm. The membrane 7 is a silicon nitride film manufactured by PE-CVD, which is formed with a tensile stress of 200 MPa or less and has a thickness of 1,400 nm.

The second cell 19 has substantially the same structure as the first cell 12. In the first cell 12, the diameter of the vibrating film 8 is 32 µm. In the second cell 19, on the other hand, the diameter of the vibrating film 16 is 44 µm. Thus, the spring constant of the vibrating film 16 is lower than the spring constant of the first cell 12. The vibrating film 16 is made of the same material and has the same thickness as the vibrating film 8. The diameter of the vibrating film 16 is set to be larger than that of the vibrating film 8, thereby decreasing the spring constant. The spring constant of the first cell 12 is 92 kN/m, and the spring constant of the second cell 19 is 55 kN/m. The spring constant as used herein refers to a value determined by dividing a load on the vibrating film by an average displacement of the vibrating film caused by the load.

According to the capacitive transducer of Example 1, an electric signal can be extracted from the second electrode with the use of lead-out wiring (not shown). In the case of receiving an ultrasonic wave by the capacitive transducer, a DC voltage is applied to the first electrodes 4 and 13 in advance. When the ultrasonic wave is received, the vibrating films 8 and 16 each including the second electrode are deformed to change the respective distances of the cavities 9 and 17 between the second electrodes 6 and 14 and the first electrodes 4 and 13, with the result that the capacitance is changed. The change in capacitance causes a current to flow through the above-mentioned lead-out wiring. This current is converted into a voltage by a current-voltage transducer (not shown). In this manner, an ultrasonic wave can be received. On the other hand, by applying a DC voltage to the first electrodes and applying an AC voltage to the second electrodes, the vibrating films 6 and 16 can be vibrated by electrostatic force. In this manner, an ultrasonic wave can be transmitted.

The capacitive transducer of Example 1 includes the first cell including the vibrating film having a high spring constant and the second cell including the vibrating film having a low spring constant, and hence the receiving frequency band width or the transmitting frequency band width can be increased. Besides, in this structure, the vibrating film 16 is made of the same material and has the same thickness as the vibrating film 8, and the insulating film 5 has a substantially uniform thickness of 100 nm, and hence the respective distances between the first electrodes and the second electrodes are substantially equal to each other. In addition, the spring constants of the vibrating films are set as described above, and the voltage at which the electrostatic attractive force becomes larger than a restoring force of the vibrating film is the pull-in voltage, and hence the pull-in voltage of the first cell 12 is higher than the pull-in voltage of the second cell 19. The pull-in voltage of the first cell 12 is 200 V, and the pull-in voltage of the second cell 19 is 100 V.

In Example 1, a voltage of 180 V is applied to the first electrode 4 of the first cell having a high spring constant of the vibrating film, and a voltage of 90 V is applied to the first electrode 13 of the second cell having a low spring constant of the vibrating film. In other words, the voltage to be applied to the first electrode 4 is set to be higher than the voltage to be applied to the first electrode 13 in a manner that the applied voltages are 90% of the pull-in voltages of the first cell 12 and the second cell 19. By applying the voltages as exemplified by this structure, the transmitting sensitivity or the receiving sensitivity can be improved. Therefore, the receiving frequency band width or the transmitting frequency band width can be increased, and the transmitting sensitivity or the receiving sensitivity can be improved.

(Example 2)

The structure of a capacitive transducer according to Example 2 of the present invention is described with reference to FIGS. 2A and 2B. FIG. 2A is a top view, and FIG. 2B is a cross-sectional view taken along the line 2B-2B of FIG. 2A. The structure of the capacitive transducer according to Example 2 is substantially the same as in Example 1. In FIGS. 2A and 2B, portions corresponding to the respective portions of FIGS. 1A and 1B are given the numbers of the respective portions of FIGS. 1A and 1B plus 20.

In Example 2, the vibrating film thickness of a cell having a higher spring constant of the vibrating film is larger than the vibrating film thickness of another cell having a lower spring constant of the vibrating film, and the vibrating film area of the cell having a higher spring constant of the vibrating film is equal to the vibrating film area of the another cell having a lower spring constant of the vibrating film. A vibrating film 28 of a first cell 32 and a vibrating film 36 of a second cell 39 both have a diameter of 32 µm. The vibrating film 28 has a thickness of 1,400 nm, and the vibrating film 36 has a thickness of 1,150 nm. According to this structure, the first cell has a spring constant of 92 kN/m, and the second cell has a spring constant of 55 kN/m. In this manner, the capacitive transducer according to Example 2 includes the first cell that includes the vibrating film having a high spring constant and the second cell that includes the vibrating film having a low spring constant, and hence the receiving frequency band width or the transmitting frequency band width can be increased.

This structure is manufactured as follows. A second electrode 26 of the first cell 32 and a second electrode 34 of the second cell 39 are formed. After that, in order to increase the thickness of the vibrating film of the first cell 32, a silicon nitride film made of the same material as that of membranes 27 and 35 is formed. After that, a part of the silicon nitride film laminated on the second electrode 34 is removed by etching. In this case, the second electrode 34 of the second cell 39 functions as an etching stop layer, and hence the distance between the second electrode 26 and the first electrode 24 of the first cell 32 can be easily set to be equal to the distance between the second electrode 34 and the first electrode 33 of the second cell 39.

Also in this structure, a pull-in voltage of the first cell is higher than a pull-in voltage of the second cell. The pull-in voltage of the first cell 32 is 200 V, and the pull-in voltage of the second cell 39 is 100 V. In Example 2, a voltage of 160 V is applied to the first electrode 24 of the cell having a high spring constant of the vibrating film, and a voltage of 80 V is applied to the first electrode 33 of the cell having a low spring constant of the vibrating film. In other words, the voltage to be applied to the first electrode 24 is set to be higher than the voltage to be applied to the first electrode 33 in a manner that the applied voltages are 80% of the pull-in voltages of the first cell 12 and the second cell 19. By applying the voltages as exemplified by this structure, the transmitting sensitivity or the receiving sensitivity can be improved.

Therefore, the receiving frequency band width or the transmitting frequency band width can be increased, and the transmitting sensitivity or the receiving sensitivity can be improved. Besides, according to this structure of the present invention, the cells have the same shape when viewed from above as illustrated in FIG. 2A, and hence the radiation impedances are matched among all the cells. The same radiation impedance of the cells means that the vibrating films of the cells are vibrated in substantially the same manner, which can prevent an undesired vibration.

(Example 3)

A probe including the capacitive transducer described in the above-mentioned embodiment or examples is applicable to a test object information acquiring device using acoustic waves. An acoustic wave from a test object is received by the capacitive transducer, and an output electric signal is used to acquire test object information that reflects an optical property value of the test object, such as a light absorption coefficient.

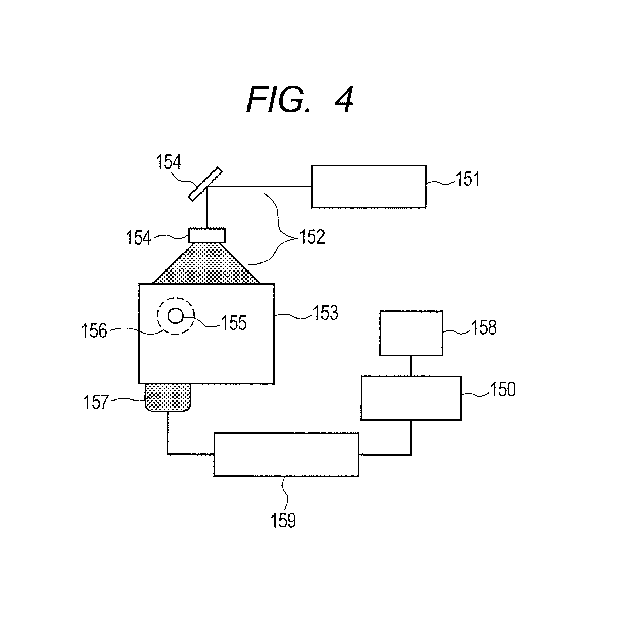

FIG. 4 illustrates a test object information acquiring device of Example 3 using a photoacoustic effect. Pulsed light 152 emitted from a light source 151 for generating light in the form of a pulse irradiates a test object 153 via an optical member 154 such as a lens, a mirror, or an optical fiber. A light absorber 155 inside the test object 153 absorbs energy of the pulsed light to generate a photoacoustic wave 156 as an acoustic wave. A probe 157, which is equipped with a casing that accommodates the capacitive transducer, receives the photoacoustic wave 156 to convert the photoacoustic wave 156 into an electric signal, and outputs the electric signal to a signal processor 159. The signal processor 159 subjects the input electric signal to signal processing such as A/D conversion and amplification, and outputs the resultant signal to a data processor 150. The data processor 150 uses the input signal to acquire test object information (test object information that reflects an optical property value of the test object, such as a light absorption coefficient) as image data. A display unit 158 displays an image based on the image data input from the data processor 150. The probe may be configured to scan mechanically or may be configured to be moved by a user, such as a doctor or an engineer, relative to the test object (handheld type). It should be understood that the capacitive transducer as an electromechanical transducer of the present invention can be used also in a test object diagnosis apparatus for detecting an acoustic wave from a test object irradiated with the acoustic wave. Also in this case, the acoustic wave from the test object is detected by the capacitive transducer, and a converted signal is processed by the signal processor, to thereby acquire information inside the test object. In this case, the capacitive transducer of the present invention can be used to transmit an acoustic wave toward the test object.

The capacitive transducer according to the present invention is applicable to an optical imaging device for acquiring information in a measurement target such as a living body, a conventional ultrasonic diagnosis apparatus, or the like. The capacitive transducer according to the present invention is applicable also to other applications including a supersonic detector.

According to the capacitive transducer of the present invention, the receiving frequency band width or the transmitting frequency band width can be increased. Besides, the voltage to be applied between the first and second electrodes of the first cell that includes the vibrating film having a high spring constant can be set to be higher than the voltage to be applied between the first and second electrodes of the second cell, and hence the transmitting sensitivity or the receiving sensitivity can be improved.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

### Reference Signs List

1 ··· capacitive transducer, 2 ··· substrate, 3, 5 ··· insulating film, 4, 13 ··· first electrode, 6, 14 ··· second electrode, 7, 15 ··· membrane, 8, 16 ··· vibrating film, 9, 17 ··· cavity (gap), 10 ··· vibrating film supporting portion, 11 ··· first voltage applying unit, 12 ··· first cell, 18 ··· second voltage applying unit, 19 ··· second cell
Provided is a capacitive transducer including an element including a plurality of cells: each of the plurality of cells including: a first electrode; and a vibrating film including a second electrode, the second electrode being opposed to the first electrode with a gap; and a vibrating film supporting portion that supports the vibrating film so as to form the gap, in which the element includes a first cell and a second cell, the first cell including the vibrating film having a first spring constant, the second cell including the vibrating film having a second spring constant lower than the first spring constant; and a voltage to be applied between the first electrode and the second electrode of the first cell is higher than a voltage to be applied between the first electrode and the second electrode of the second cell.

## Claims

1. A capacitive transducer comprising an element comprising a plurality of cells,
each of the plurality of cells comprising:
a first electrode;
a vibrating film comprising a second electrode, the second electrode being opposed to the first electrode with a gap; and
a vibrating film supporting portion that supports the vibrating film so as to form the gap;
wherein the element comprises a first cell and a second cell, the first cell comprising the vibrating film having a first spring constant, the second cell comprising the vibrating film having a second spring constant lower than the first spring constant,
wherein a voltage to be applied between the first electrode and the second electrode of the first cell is higher than a voltage to be applied between the first electrode and the second electrode of the second cell.

2. The capacitive transducer according to claim 1, wherein:
the element comprises a plurality of the first cells or a plurality of the second cells; and
the first electrodes or the second electrodes of the plurality of the first cells or the plurality of the second cells are electrically coupled to one another.

3. The capacitive transducer according to claim 1 or 2, wherein the vibrating film of the first cell has an area smaller than an area of the vibrating film of the second cell, and the vibrating film of the first cell has a thickness equal to a thickness of the vibrating film of the second cell.

4. The capacitive transducer according to claim 1 or 2, wherein the vibrating film of the first cell has a thickness larger than a thickness of the vibrating film of the second cell, and the vibrating film of the first cell has an area equal to an area of the vibrating film of the second cell.

5. A test object information acquiring device, comprising:
the capacitive transducer according to any one of claims 1 to 4;
a voltage applying unit configured to apply a voltage between the first electrode and the second electrode of the capacitive transducer; and
a signal processor configured to process a signal output from the capacitive transducer,
wherein the capacitive transducer is configured to receive an acoustic wave, and the signal processor is configured to process a signal obtained by conversion into an electric signal, to thereby acquire information on the test object.

6. The test object information acquiring device according to claim 5, further comprising a light source configured to emit light,
wherein the capacitive transducer is configured to receive an acoustic wave generated by the light that has been emitted from the light source to irradiate a test object, and the signal processor is configured to process a signal obtained by conversion into an electric signal, to thereby acquire information on the test object.

7. A method of manufacturing the capacitive transducer according to any one of claims 1 to 4, the method comprising:
forming a first electrode of each of the first cell and the second cell;
forming a sacrificial layer on the first electrode in order to form a gap of the each of the first cell and the second cell;
forming, on the sacrificial layer, at least a part of a vibrating film of the each of the first cell and the second cell; and
removing the sacrificial layer,
wherein the forming a sacrificial layer comprises setting an area of a sacrificial layer that forms the gap of the first cell to be smaller than an area of a sacrificial layer that forms the gap of the second cell, and
wherein the forming at least a part of a vibrating film of the each of the first cell and the second cell comprises setting a thickness of the vibrating film of the first cell to be equal to a thickness of the vibrating film of the second cell.

8. A method of manufacturing the capacitive transducer according to any one of claims 1 to 4, the method comprising:
forming a first electrode of each of the first cell and the second cell;
forming a sacrificial layer on the first electrode in order to form a gap of the each of the first cell and the second cell;
forming, on the sacrificial layer, at least a part of a vibrating film of the each of the first cell and the second cell; and
removing the sacrificial layer,
wherein the forming a sacrificial layer comprises setting an area of a sacrificial layer that forms the gap of the first cell to be equal to an area of a sacrificial layer that forms the gap of the second cell, and
wherein the forming at least a part of a vibrating film of the each of the first cell and the second cell comprises setting a thickness of the vibrating film of the first cell to be larger than a thickness of the vibrating film of the second cell.
